Europäisches Patentamt

European Patent Office

Office européen des brevets

(11) Publication number: **0 094 247**
A1

## EUROPEAN PATENT APPLICATION

(21) Application number: **83302638.8**

(22) Date of filing: **10.05.83**

(51) Int. Cl.³: **G 03 F 7/26,** H 01 L 21/31,
H 01 L 21/00

(30) Priority: **10.05.82 GB 8213508**

(43) Date of publication of application: **16.11.83**
**Bulletin 83/46**

(84) Designated Contracting States: **AT BE CH DE FR GB IT
LI LU NL SE**

(71) Applicant: **BRITISH TELECOMMUNICATIONS,
2-12 Gresham Street, London EC2V 7AG (GB)**

(72) Inventor: **Pollard, Christopher John, 19 Roxburgh Road,
Ipswich Suffolk IP4 3HW (GB)**
Inventor: **Morgan, Russell Alan, Blandford, Alderton
Road, Hollesley Suffolk (GB)**

(74) Representative: **Purell, Kevin John, British Telecom
Intellectual Property Unit 13th Floor 151 Gower Street,
London WC1E 6BA (GB)**

(54) **A method of hardening resist material.**

(57) An organic photoresist mask (4), used in the fabrication of
semiconductor devices (1), is hardened before dry etching of
a surface of the device (1). The hardening is carried out by
exposure to an electron beam (6) and is intended to reduce the
rate of erosion of the photoresist material (4) by the etchant.

EP 0 094 247 A1

A METHOD OF HARDENING RESIST MATERIAL

The invention relates to a method of hardening polymeric resist material used in the production of semiconductor devices.

The production of integrated circuits requires patterned areas of coating materials such as silicon dioxide, aluminium, silicon nitride and polycrystalline silicon on specific regions of the integrated circuit. A known method of achieving the patterned areas of coating materials comprises deposition of the required material in a continuous coating on the integrated circuit substrate, covering the required material with a layer of sensitive (resist) material, exposure of the resist material to an activating agent in the required pattern, development of the resist material to remove that material not required, removal by etching of the deposited material previously covered by the resist material but now exposed by the partial removal of the resist material in the required pattern, and finally removal of the remaining resist material.

Resist materials sensitive to different activating agents are known. These include electron resist and photoresist materials. In the former case, electron resist material is exposed to incident electrons by means of, for instance, a projected or scanned electron beam. The required pattern can be generated by projecting the electron beam through a form of mask, or by controlling the scan direction or beam power of a scanned electron beam. Use of electron beams and electron resist materials in this way, known as electron beam lithography, is described in the following publication:-

"Electron-beam lithography draws a finer line" by
T H P Chang, M Hatzakis, A D Wilson and A N Broers.
Electronics International, Volume 50, Part 10,
1977, New York (US), pp 89-98.

The present invention relates however to the use of photoresist materials, sensitive to incident photons, and in particular to the use of positive photoresist materials. In this case the required pattern can be generated by exposing the resist material to electromagnetic radiation such as ultraviolet light, through a mask. Development of the resist material removes that material not exposed to the radiation by virtue of the mask.

With regard to the subsequent etching step, mentioned above, it is known to carry out etching of a sample by means of the application of chemicals in liquid form. These processes, known as wet etching processes, are isotropic however and as a result tend to undercut the pattern of photoresist material. Where device geometries are required to be small, particularly at feature sizes of 2μm and below, it is desirable to employ an anisotropic etching technique, in which the etching component perpendicular to the surface of a semiconductor device is very much greater than the lateral component. Accordingly dry etching techniques, such as plasma etching, which expose a sample to normal incidence ions which react at the point of impact to produce a volatile product, have been developed. These result in a well defined perpendicular edge to the etched profile and accurate replication of the photoresist pattern in the etched layer.

Such dry etching techniques however are not selective in their etching action. Unless measures are taken to harden the photoresist pattern, that also will be etched, leading in extreme cases to complete breakthrough and exposure of the underlying layer. Such hardening can be achieved by heating, typically to 120°C for 15 minutes. This is an inefficient process since it produces only a limited degree of cross-linking in the photoresist polymer and so does not enhance substantially its etch resistance. Treatment at a higher temperature will increase the degree of cross-linking but if the glass transition temperature is exceeded, flow of the photoresist polymer will occur. The result of such flow is a rounded cross section of the photoresist pattern which leads to bevelling of the etched profile and ultimately to trapezoidal, rather than rectangular, cross sections of etched features on the semiconductor device. If overetching is employed to ensure complete removal of material not covered by the photoresist pattern, irremediable loss of line width in the final circuit pattern can occur; the rounded cross section produced by flow means that the thickness of the photoresist material is reduced towards the edges of pattern features.

A known method of combatting flow of the photoresist polymer under heat treatment is to introduce an electron beam radiation step before the heat treatment. Two such arrangements are described in the following publications:-

"Resist stabilization by electron beam" by B J Canavello, V Di Milia and M Hatzakis. IBM Technical Disclosure Bulletin, Volume 22, No. 5, 1979, New York (US), p 2134.

"Single-layer photoresist profiling" by H Bohlen, J Greschner and H J Trumpp. IBM Technical Disclosure Bulletin, Volume 23, No. 8, 1981, New York (US), p 3740.

Flow stabilisation is achieved by exposing the surface of the resist material to an electron beam dose equal to or above about $1 \times 10^{-5}$ Coulomb/cm². Such exposure produces a protective skin on the resist material which acts to prevent it changing its outer geometry during a subsequent heat hardening step. Thermal hardening of the photoresist material preceded by a flow stabilisation step however increases the number of steps involved in the production of semiconductor devices.

- 4 -

A second disadvantage of thermal hardening is that adhesion of the photoresist material to the substrate is increased. Removal of the remaining photoresist material after the etching stage is made more difficult by such increased adhesion.

A third disadvantage is that volatile components of the resist material can be removed by thermal hardening, altering the characteristics of the photoresist polymer.

The method of the present invention seeks to avoid the use of high temperatures in the hardening of resist materials and to produce the larger part of the hardening effect in a region close to the major exposed surface of the resist material such that there is no, or a negligible, increase in adhesion of the resist material to the deposited material substrate.

A further advantage of the method of the invention lies in the greater efficiency of bond breaking by an electron beam compared with heat treatment of photoresist material, causing a greater degree of cross-linking and therefore greater resistance of the resulting molecular matrix to dry etching.

According to the present invention there is provided a method of fabricating a semiconductor device by lithography, the method including the steps of applying an organic photoresist material to a surface of the device for defining a pattern thereon prior to dry etching of the surface of the device, the method further including the step of hardening the photoresist material by irradiation with an electron beam, molecular chains in the photoresist material being cross-linked thereby sufficiently to reduce erosion of the resist material during the dry etching step.

An embodiment of the invention will now be described, by way of example only, with reference to the accompanying drawings in which:-

Figure 1   shows a cross section of part of a semiconductor device undergoing electron beam hardening

Figure 2   shows a view from above of the arrangement of Figure 1, including a representation of a suitable electron beam raster pattern.

Figure 3 shows an alternative electron beam raster pattern.

Figure 4 shows a variation of the arrangement of Figure 1.

Figure 5 shows a graphical representation of the results of tests carried out regarding loss of resist material, hardened according to the invention, during etching.

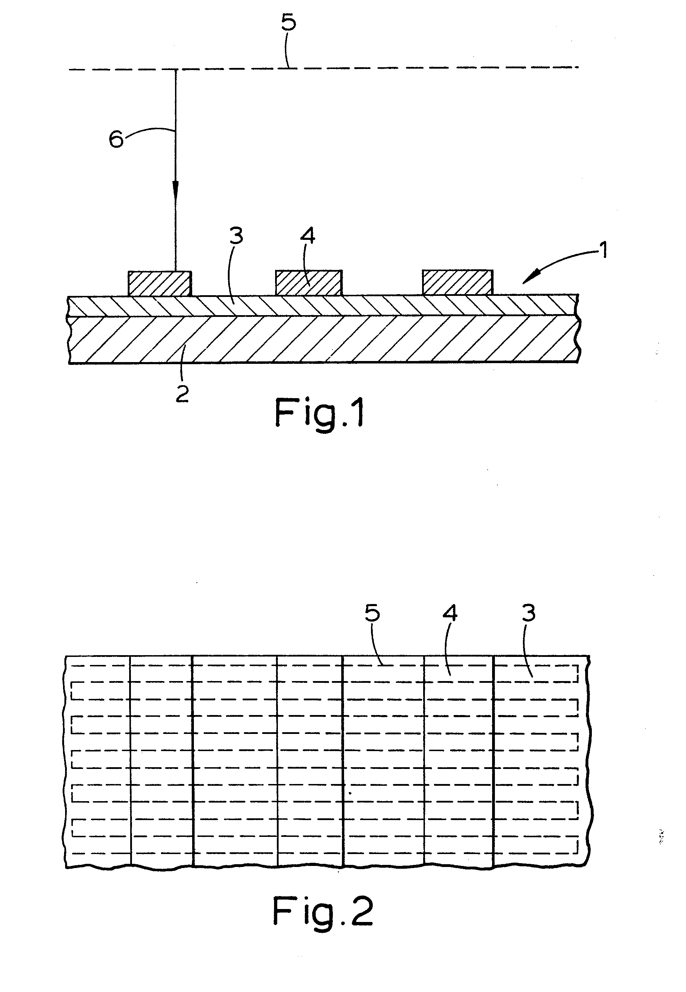

Referring to Figure 1, resist material 4 used in the production of a semiconductor device 1 is hardened at the stage of production after development of the resist material 4 to remove that resist material which was not previously exposed, and before etching of the deposited material 3 in the regions exposed by development of the resist material 4. The deposited material 3 is supported by a substrate 2.

Hardening is carried out by scanning in a raster pattern 5, of the surface of the semiconductor device 1 bearing the resist material 4, with an electron beam 6, the electron beam 6 being aimed in a direction substantially perpendicular to the major exposed surface of the resist material 4.

Any convenient form of raster pattern 5 may be employed, such as a rectangular grid (as shown in Figure 2). A constraint on the raster pattern 5 and the length of time of exposure of the resist material to the electron beam 6 however is that all the major exposed surface of the resist material 4 must receive a total injected charge sufficient to produce cross-linking of the polymer chains in the resist material without raising its temperature to approach its glass transition temperature.

The total injected charge is dictated by the combination of the energy of the electron beam and the length of time the resist material is irradiated. It has been found that a total injected charge of more than 0.5m Coulombs.cm$^{-2}$ produces the desired cross-linking, good results being obtained at 5.0mC.cm$^{-2}$ with regard to hardening of the resist material. An upper limit to the total injected charge is set by the glass transition temperature of the particular resist material used since the temperature is raised, with a higher total injected charge, to a higher level during hardening.

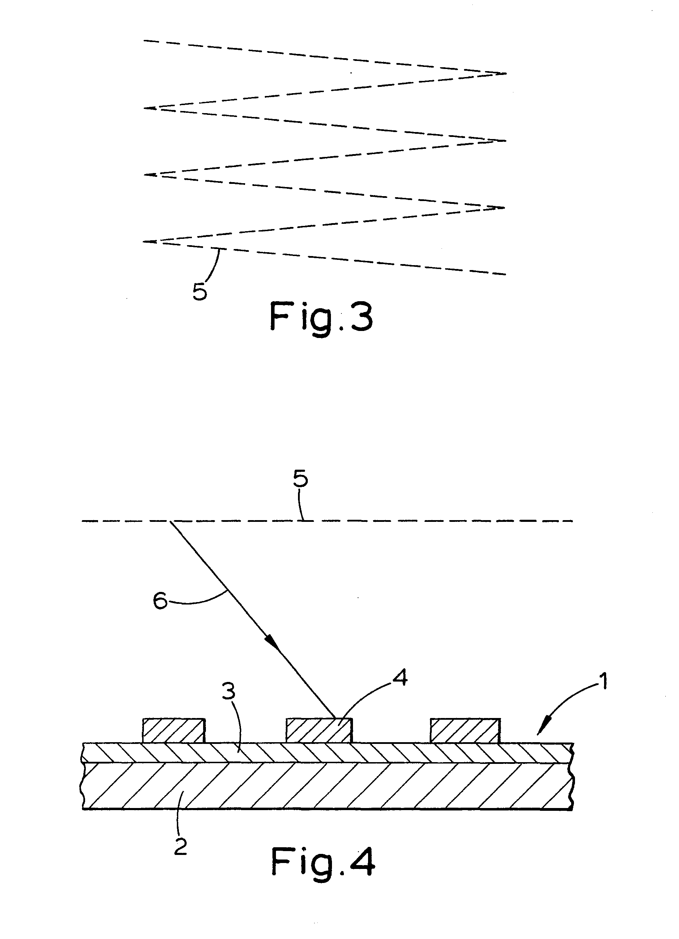

Referring to Figure 3, for the following experiments, designed to investigate the effects of electron beam hardening according to an embodiment of the present invention, a triangular raster pattern 5 was employed.

## Experimental

A Novolak photoresist (HPR 206) was studied. This was spin-coated to a thickness of 1.9μm on wafers with deposited aluminium and polysilicon layers of thicknesses varying from 0.5μm to 1 μm. The samples were then infra-red soft-baked at 82°C for 10 min to remove excess solvent, optically exposed to a test mask including features down to 1μm linewidth and developed using a conventional wet chemical process.

The samples were then split into three groups. The first group was used to investigate the thermal hardening process and plastic flow characteristics of the resist at temperatures ranging from 120°C to 200°C. An infra-red heater was used to heat the samples, and the temperature range was chosen to examine the resist behaviour both below and above the glass transition

- 7 -

temperature (typically 130°C for this type of resist in its unhardened state) at which the onset of flow would be expected.

The second group of samples was exposed to a 10 keV scanned electron beam in an electron beam annealing system modifed to produce a beam current of about 1 mA, in which the wafer surface was irradiated by a rapidly scanned (20 kHz by 100 Hz) focused electron beam with a spot size of approximately 250μm. Total integrated charge doses of 0.5 mCcm$^{-2}$ to 10 mCcm$^{-2}$ were used. During the exposure the wafers were held in thermal isolation by mounting on three silicon micropoints: thus the temperature to which the samples rose during irradiation could be accurately controlled via the dose rate. Sample temperatures during e-beam irradiation ranged from 80°C (dose rate of 0.011 mCcm$^{-2}$s$^{-1}$) to 200°C (0.034 mCcm$^{-2}$s$^{-1}$). Flow characteristics during exposure could thus be established and compared with conventional heating. The third sample group was retained as a control to monitor changes in resist thickness, line profile and plasma etch rate.

Following heat treatment or electron exposure, the resist profiles were visually examined by scanning electron microscopy and the change in resist thickness using a Tencor Alphastep step height monitor. The samples were then plasma-etched in a planar plasma reactor using a carbon tetrachloride plasma (for both silicon and aluminium films) or chlorine plasma (for silicon films only), after which the change in resist thickness (resist loss) and the subsequent etched line profile was examined in the scanning electron microscope (SEM).

### Results and Discussion

The resistance to plasma etching can be estimated from the percentage resist loss during exposure to the plasma. The thermally hardened resist samples showed a slight decrease in resist loss during plasma etching for bake temperatures up to 125°C. For temperatures above this, resist flow became evident resulting in degradation of the line profile, the degree of flow increasing with temperature. The plasma etch resistance for samples baked above 130°C was not investigated as the rounded line profile resulting from flow made thickness and thickness change measurements highly inconsistent.

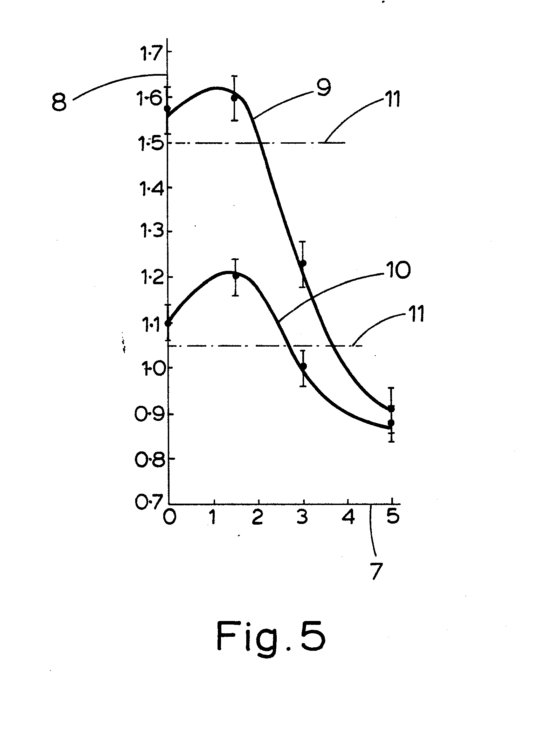

Referring to Figure 5, electron dose 7 in $mC.cm^{-2}$ was plotted against resist loss values 8 in µm during the etching of a 3µm polysilicon line in a chlorine plasma 9 and in a carbon tetrachloride plasma 10. Thermally hardened controls 11 were included for comparison. The initial thickness of the resist material was 1-9 µm.

It was observed that no resist flow occurred in the electron beam irradiated samples, even those which had experienced temperatures > 180°C during irradiation. This is interpreted as being due to the short time spent by the samples above the (unprocessed resist) glass transition temperature (3 min for a sample exposed to $5mCcm^{-2}$ and a peak temperature of 180°C). Flow time constants are high in comparison to the exposure time due to the high viscosity of the resist at these temperatures. It is also likely that the glass transition temperature, tg, which is a function of the degree of crosslinking, increases during the electron exposure; thus the final value of tg for the crosslinked resist is greater than the peak exposure temperature. Also tg has not been exceeded during the course of the electron beam exposure due to the relationship between the heating rate in the resist material (2.5 degrees Kelvin per second), under the conditions employed, and the rate at which cross-linking takes place in the resist material. The latter rate was high enough always to produce sufficient cross-linking to raise tg above the instantaneous temperature of the resist material.

Following etching in chlorine and carbon tetra-ch loride plasmas, the electron beam treated samples showed an increased resist erosion rate for doses < 2 mCcm$^{-2}$, but for doses greater than this, the erosion rate fell dramatically to a near constant value above 5 mCcm$^{-2}$ (Figure 5).

It is interesting to note here that the known effect of an electron beam to stabilise resist material against flow under subsequent thermal hardening takes place at doses of about 1 x 10$^{-5}$C.cm$^{-2}$. Since it appears that such doses produce _increased_ resist erosion rates under plasma etching, quite different criteria for the two applications of electron beams are indicated.

Removal of the electron beam hardened resists was achieved in fuming nitric acid, and no enhanced adhesion or postremoval residue problems were encountered.

It is not necessary that the rate of charge injection remain constant during irradiation; it has been noted above that an advantageous effect of cross-linking by the use of an electron beam appears to be an increase in the glass transition temperature of the resist material. This allows an increase in the rate of charge injection as the treatment progresses which also reduces the time given to the resist hardening step in the production of integrated circuits.

The rate of charge injection can be varied in more than one way. For instance the electron beam current may be changed. However, more conveniently in the case of a scanned electron beam, the area over which the electron beam is scanned may be altered. For example, in practice a wafer 75mm in diameter may be irradiated by an electron beam which is actually scanned in a square raster pattern covering an area measuring 10cm x 10cm, within which the wafer lies. If the total electron beam current is 1.0 mA the effective share received per $cm^2$ at the wafer surface will be 0.01 mA. If the raster pattern is altered to cover an area measuring only 5cm x 5cm the effective share received per $cm^2$ at the wafer surface will increase to 0.04 mA. Any parameters chosen for changes in the charge injection rate will depend at least partially on the conditions required in each case of irradiation and could be varied as found suitable by a person skilled in the art.

The rectangular and triangular raster patterns 5 mentioned above, for application in the irradiation of resist materials 4 according to the invention, are intended to approximate to flood exposure of the resist material 4. Another convenient form of raster pattern 5 may be that employed in scanning the electron beam of a television tube which incorporates parallel interlaced scan lines, flyback of the electron beam being used between consecutive lines. Alternatively, it may be convenient to replace a scanned electron beam system with a system providing flood exposure directly.

Referring to Figure 4, it may well be preferred to use other than normal incidence of the electron beam 6 on the surface of the resist material 4. If the thickness of the resist material 4 is particularly small, there may be a risk that adhesion to the substrate of deposited material 3 is increased.  By changing the incident angle of the electron beam 6, increased adhesion may be avoided.

Although the experiments described above were carried out on a Novolak photoresist, it should be noted that hardening by electron beam treatment can be applied to any organic, polymeric resist material.

0094247

- 12 -

CLAIMS

What we claim is:-

1.  A method of fabricating a semiconductor device (1) by lithography, the method including the steps of applying an organic photoresist material (4) to a surface of the device (1) for defining a pattern thereon prior to dry etching of the surface of the device (1), the method further including the step of hardening the photoresist material (4) by irradiation with an electron beam (6), molecular chains in the photoresist material (4) being cross-linked thereby sufficiently to reduce erosion of the resist material (4) during the dry etching step.

2.  A method according to Claim 1 wherein the rate of charge injection is varied during the course of irradiation of the resist material (4).

3.  A method as described in Claim 1 wherein the total charge injected per unit area of the major exposed surface of the resist material (4) during the course of irradiation is equal to or more than 0.5 mCoulombs $cm^{-2}$ but less than a value sufficient to raise the temperature of the resist material (4) above the glass transition temperature of the resist material (4) concerned under the conditions of irradiation employed.

4.  A method according to Claim 3 wherein irradiation of the resist material (4) with an electron beam (6) is carried out by scanning the electron beam (6) in a raster pattern (5) over the surface of the resist material (4).

5. A method according to Claim 3 wherein irradiation of the resist material (4) with an electron beam (6) is carried out by projection of the electron beam (6) onto the surface of the resist material (4).

6. A semiconductor device (1) fabricated according to the method described in Claim 1.

5

6

3

4

1

2

Fig.1

5 4 3

Fig.2

Fig.3

Fig.4

0094247

Fig.5

European Patent
Office

**EUROPEAN SEARCH REPORT**

Application number

EP 83 30 2638

| | **DOCUMENTS CONSIDERED TO BE RELEVANT** | | |
|---|---|---|---|
| Category | Citation of document with indication, where appropriate, of relevant passages | Relevant to claim | CLASSIFICATION OF THE APPLICATION (Int. Cl. 3) |
| X,Y D | IBM TECHNICAL DISCLOSURE BULLETIN, vol. 22, no. 5, October 1979, page 2134, New York, USA B.J. CANAVELLO et al.: "Resist stabilization by electron beam" * Whole article * | 1 | G 03 F 7/26 H 01 L 21/31 H 01 L 21/00 |
| | --- | | |
| X,Y D | IBM TECHNICAL DISCLOSURE BULLETIN, vol. 23, no. 8, January 1981, page 3740, New York, USA H. BOHLEN et al.: "Single-layer photoresist profiling" * Whole article * | 1 | |
| | --- | | |
| Y,D | ELECTRONICS INTERNATIONAL, vol. 50, no. 10, May 1977, pages 89-98, New York, USA T.H.P. CHANG et al.: "Electron-beam lithography draws a finer line" * Figure 5 * | 1 | **TECHNICAL FIELDS SEARCHED (Int. Cl. 3)** G 03 F 7/26 H 01 L 21/31 H 01 L 2/00 |
| | --- | | |
| A | EP-A-0 005 164 (IBM) * Abstract * | 1 | |
| | ---     -/- | | |

The present search report has been drawn up for all claims

| Place of search | Date of completion of the search | Examiner |
|---|---|---|
| THE HAGUE | 05-08-1983 | RASSCHAERT A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82

0094247

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | ELECTRONICS LETTERS, vol. 16, no. 8, 10th April 1980, pages 295-297, London, GB. R.A. McMAHON et al.: "Characterisation of multiple-scan electron beam annealing method" * Whole article * | 1 | |
| A | IBM TECHNICAL DISCLOSURE BULLETIN, vol. 14, no. 10, March 1972, page 2899, New York, USA W.J. KLEINFELDER et al.: "Ion bombardment to change physical properties of organic polymers" * Whole article * | 1 | |
| A | US-H- 883 005 (M.J. SCHULLER) | 1 | TECHNICAL FIELDS SEARCHED (Int. Cl. ³) |
| P,X | ELECTRONICS LETTERS, vol. 18, no. 24, 25th November 1982, pages 1038-1040, London, GB. R.A. MORGAN et al.: "Enhancement of resist plasma erosion rates by electron-beam hardening" * Whole article * | 1-6 | |

The present search report has been drawn up for all claims

| Place of search | Date of completion of the search | Examiner |
|---|---|---|
| THE HAGUE | 05-08-1983 | RASSCHAERT A. |